Europäisches Patentamt

European Patent Office

Office européen des brevets

(19)

(11) **EP 0 940 839 A2**

(12) **EUROPÄISCHE PATENTANMELDUNG**

(43) Veröffentlichungstag:
08.09.1999 Patentblatt 1999/36

(51) Int. Cl.$^6$: **H01J 37/32**

(21) Anmeldenummer: 99109578.7

(22) Anmeldetag: 24.05.1991

(84) Benannte Vertragsstaaten:
**CH DE FR GB LI NL**

(30) Priorität: **17.07.1990 DE 4022708**

(62) Dokumentnummer(n) der früheren Anmeldung(en)
nach Art. 76 EPÜ:
**91108433.3 / 0 467 046**

(71) Anmelder:
**BALZERS AKTIENGESELLSCHAFT**
**9496 Balzers (LI)**

(72) Erfinder: **Wellerdieck,Klaus,Dr.**
**9470 Buchs (CH)**

(74) Vertreter:
**Troesch Scheidegger Werner AG**
**Patentanwälte,**
**Siewerdtstrasse 95,**
**Postfach**
**8050 Zürich (CH)**

Bemerkungen:
This application was filed on 14 - 05 - 1999 as a
divisional application to the application mentioned
under INID code 62.

(54) **Aetz- oder Beschichtungsanlagen**

(57) Ätz-oder Beschichtungsanlage mit einem Vakuumrezipienten (1) und einem Paar beabstandeter Elektroden (5, 9) zur Erzeugung einer kapazitiven Plasmaentladung im Repizienten (1). Die den Rezipienten umspannende Wandung (3) ist in zwei voneinander isolierte (7) Teile (5, 9) unterteilt, die beide der elektrischen Signalübertragung an ihre innenliegenden, als Elektrodenflächen ($F_A$, $F_B$) dienenden Flächen dienen, wobei mit der Unterteilung der Rezipientenwandung (3) gesteuert wird, welche der Elektroden (5, 9) abgetragen bzw. welche beschichtet wird und ein Verfahren zum Zünden von Plasmaentladungen und deren intermittierendem Betrieb.

FIG.1

EP 0 940 839 A2

## Beschreibung

Die vorliegende Erfindung betrifft Aetz- oder Beschichtungsanlagen sowohl für rein physikalische Prozesse wie auch für plasmaunterstützte chemische Prozesse PECVD, mit einem Vakuumrezipienten und einem Paar beabstandeter Elektroden zur kapazitiven Erzeugung einer AC-Plasmaentladung im Rezipienten, ein Verfahren zum Zünden von Plasmaentladungen, Verfahren zu deren intermittierendem Betrieb.

Sputteranlagen der genannten oder ähnlicher Art sind bekannt aus: DE-OS 1 790 178, DE-OS 2 022 957, DE-OS 3 706 698, EP-A-0 271 341, US-A-4 572 759, 4 278 528, 4 632 719, 4 657 619, 4 132 613, 4 557 819, 4 466 872, 4 552 639, 4 581 118, 4 166 018, GB-A-1 587 566, 1 569 117, 1 358 411, 1 111 910, 1 258 301, 2 157 715. Dabei ist es üblich, entweder beide Elektroden zur kapazitiven Plasmaanregung, wie beispielsweise aus der EP-A-0 271 341 ersichtlich, elektrisch, über isolierende Durchführungen durch die Rezipientenwandung hindurch zu betreiben oder lediglich eine der Elektroden, und dann die gesamte Rezipientenwand als zweite Elektrode zu verwenden, beispielsweise und insbesondere als "Anode" auf Masse zu schalten.

Zur Physik der sog. AC- oder insbesondere HF-Zerstäubungstechnik sei hingewiesen auf H.R. Koenig und L.I. Maissel, IBM J.Res.Develop. 14, March 1970, p. 168, weiter auf den Fachbericht BB 800 015 DD (8404) der Firma Balzers, K. Höfler und K. Wellerdieck, sowie auf die Dissertation von K. Wellerdieck "Die Potentialverteilung in Hochfrequenz-Gasentladung der Zerstäubungstechnik", 1988, Universität Karlsruhe.

Die bis anhin bekannten Vorgehen, nämlich entweder beide Elektroden oder auch nur eine von der Rezipientenwandung elektrisch isoliert über Durchführungen zu betreiben, weisen folgende Nachteile auf:

Es bedingt das Vorsehen mindestens einer vakuumdichten, isolierenden Durchführung durch die Rezipientenwandung. Es wird weiter durch die mindestens eine von der Rezipientenwandung abgesetzte Elektrode relativ viel Prozessraum versperrt und der Rezipient deswegen relativ voluminös.

Wird die elektrische Speisung einer der Elektroden vakuumdicht und isoliert durch die Rezipientenwandung durchgeführt und diese Wandung, als Ganzes, als zweite Elektrode, z.B. auf Massepotential liegend eingesetzt, so ist man bezüglich der Auslegung der Flächenverhältnisse der Elektrodenflächen, die dem Rezipienteninnenraum zugewandt sind, ausserordentlich eingeschränkt. Ueblicherweise wird dann die durch die ganze Rezipientenwandung gebildete Elektrode in ihrer Fläche wesentlich grösser als diejenige der Elektrode mit der Durchführung.

Da ein zu ätzendes Werkstück an der kleineren der Elektroden angeordnet werden muss (Flächen/Spannungsgesetz von Koenig), in diesem Falle also an der erwähnten Elektrode mit Durchführung, und üblicherweise diese und nicht das Rezipientengehäuse bzw. die Rezipientenwand auf AC-Potential gelegt wird, muss ein zu ätzendes Werkstück in diesem Falle auf Potential gelegt werden. Dabei liegt es nicht nur auf AC-Potential, denn es ist diese kleinere Elektrode, die, aufgrund der Entladung, auch ein DC-Potential entwickelt (self-bias-Potential). Ein auf Spannung liegendes Werkstück (auf kleinerer Elektrode mit Durchführung, Rezipientenwand auf Bezugspotential) ist wesentlich aufwendiger für jede Art von automatischem Handling.

Zusammenfassend kann mithin ausgeführt werden, dass eine im Rezipienteninnern, von der Rezipientenwand örtlich getrennte und davon elektrisch isoliert betriebene Elektrode Raum einnimmt, der bei Auslegung des Rezipienten zu berücksichtigen ist, weiter eine vakuumdichte Durchführung durch die Rezipientenwand erfordert, und dass schliesslich durch eine solche Elektrode die Flexibilität bezüglich der Zuordnungen von grosse/kleine Elektrodenfläche (Koenig) Bezugspotential/DC-Schwebe-Potential eingeschränkt wird.

Die vorliegende Erfindung setzt sich zum Ziel, eine Anlage obgenannter Art zu schaffen, bei der, in möglichst kompakter Bauweise, die genannten Nachteile behoben werden.

Zu diesem Zwecke zeichnet sich die vorliegende Erfindung einerseits nach dem Wortlaut von Anspruch 1 aus.

Dadurch, dass das Rezipientengehäuse bzw. dessen Wandung beide Elektroden bildet, fällt einerseits der für das freie Vorsehen der einen der Elektroden benötigte Rezipienteninnenraum weg, ebenso die isolierte elektrische Durchführung, und zudem wird es durch die erwähnte Aufteilung der Wandungsfläche möglich, das Verhältnis der Elektrodenflächen gezielt gross auszulegen, ohne das Bauvolumen des Rezipienten dadurch wesentlich zu beeinflussen.

Wird die Erfindung nun anderseits nach dem Wortlaut von Anspruch 2 ausgebildet, so fällt an der dort erwähnten Elektrode wiederum die Vakuumdurchführung weg. Eine solche Elektrode bildet einen Teil der Wandung, kann weiter direkt als kapazitive, DC-Potential entkoppelnde Elektrode aufgebaut sein, ohne dass hierfür eine Entkopplungskapazität vorgeschaltet werden müsste.

Vorsehen der nach innen liegenden, dielektrischen Schicht bewirkt, gleichspannungsmässig, eine Entkopplung von Entladungsstrecke zu der aussenliegenden elektronenleitenden Fläche. Es kann weiter ein beliebiger Anteil der Rezipientenwandungsfläche als solche "kapazitive" Elektrodenfläche benutzt werden, womit auch hier grösstmögliche Flexibilität zur gezielten Auslegung der Anlage unter Berücksichtigung der Koenig-Formel erreicht wird.

Anders als in der US-A-4 572 759 ausgeführt, wird erfindungsgemäss die dielektrische Schicht nicht als in Prozess verbrauchte Schutzschicht, die flüchtige Reaktionsprodukte bildet, eingesetzt, sondern als wesentliche, kapazitätbildende Lage.

Liegt dabei die dielektrische Schicht gemäss Anspruch 3 gegen das Rezipienteninnere frei, so wird weiter folgender Vorteil erzielt:

Bekanntlich ist das Verhältnis von Abtragen (Aetzen) und Beschichten, wie erwähnt wurde, durch das Flächenverhältnis der Elektroden bestimmt. Je grösser das Verhältnis zwischen der Fläche der einen Elektrode und der Fläche der anderen ist, desto weniger wird die grössere Elektrode abgetragen bzw. abgeätzt, und desto weniger wird die kleinere Elektrode beschichtet. Es handelt sich dabei aber um ein Wirkungsgleichgewicht, auch die grössere der beiden Elektroden wird immer abgetragen.

Soll nun ein Werkstück geätzt werden und wird es mithin im Bereiche der kleineren Elektrode angeordnet, so ergibt der nicht gänzlich zu verhindernde Abtrag der grösseren Elektrode eine Störbeschichtung des zu ätzenden Werkstückes.

Auch wenn ein Werkstück beschichtet wird und mithin im Bereich der grösseren Elektrode angeordnet wird, um durch abgetragenes Targetmaterial, im Bereiche der kleineren Elektrode vorgesehen, beschichtet zu werden, so ergibt sich gegebenenfalls durch den Abtrag bzw. das Absputtern auch der grösseren Elektrode eine Störbeschichtung.

Diese Störungen sind dann nachteilig, wenn die daran beteiligten Materialien nicht prozesskonform sind, d.h. einerseits, bei einem zu beschichtenden Material, die Störbeschichtung, von der grösseren Elektrode, nicht mit einem Material erfolgt, das z.B. gleich dem Werkstücksubstrat oder dem gewollten Beschichtungsmaterial ist, anderseits, bei einem zu ätzenden Werkstück, die Störbeschichtung von der grösseren Elektrode nicht z.B. mit dem Werkstücksubstratmaterial erfolgt. Dadurch, dass nun nach dem erwähnten Anspruch 3 die innenliegende Elektrodenschicht aus einem dielektrischen Material gewählt werden kann, ist es ohne weiteres möglich, als dieses dielektrische Material ein dem Werkstücksubstrat entsprechendes Material oder ein den Behandlungsprozess bzw. dessen Resultat nicht störendes Material zu wählen, beispielsweise $SiO_2$ bei einem Substrat bzw. Werkstück aus $SiO_2$ oder mit $SiO_2$-Oberfläche.

Es versteht sich nun von selbst, dass eine oder zwei Elektroden nach Anspruch 2 eine bzw. beide Elektroden der nach Anspruch 1 aufgebauten Anlage bilden können.

Bei Ausbildung mindestens einer Elektrode nach dem Wortlaut von Anspruch 2, wird weiter vorgeschlagen, dass die elektronenleitende Fläche durch eine die Vakuumbelastung aufnehmende Metallpartie der Rezipientenwandung gebildet wird, dies nach dem Wortlaut von Anspruch 4. Dabei wird berücksichtigt, dass dielektrische Materialien nur bei hoher Schichtdicke in der Lage sind, grossflächig die erwähnten Belastungen aufzunehmen, und dass mit zunehmender Schichtdicke deren spezifische Kapazität abnimmt.

Damit wird man in vielen Fällen bestrebt sein, möglichst dünne dielektrische Schichten einzusetzen, z.B. um mit geringst möglichen Verlusten über dieser Schicht eine grösstmögliche AC-Energie in den Prozessraum übertragen zu können.

Gemäss Wortlaut von Anspruch 5 wird nun weiter die durch die Koenig-Formel gegebene Anweisung konsequent eingesetzt.

Im weiteren ist es bekannt, dass, bei kapazitiver Plasmaerzeugung, die eine der Elektroden, über eine diskrete Kapazität, bezüglich DC-Potential entkoppelt bzw. frei schwebend betrieben werden muss, damit sich daran das self-bias-Potential einstellen kann.

Dadurch, dass nun gemäss Wortlaut von Anspruch 6 mindestens eine der Elektroden zwei- oder mehrschichtig, d.h. in Sandwichbauweise ausgebaut ist, wird folgendes erreicht:

Ist diese Elektrode durch eine aussenliegende Metallfläche und eine gegen das Rezipienteninnere freiliegende, dielektrische Schicht gebildet, so bildet diese äussere Metallfläche, die anschliessende dielektrische Schicht und der angrenzende Prozessraum mit freien Ladungsträgern, eine Kapazität, äquivalent zu bekannten metallischen Elektroden mit ihr seriegeschalteter diskreter Kapazität. Die erfindungsgemäss aufgebaute Elektrode übernimmt zusätzlich die Aufgabe der DC-Entkopplungskapazität.

Wird vorgezogen, die dem Rezipienteninneren zugewandte Elektrodenfläche wiederum als metallische Fläche auszubilden, so bildet letztere, die diesbezüglich nach aussen anschliessende dielektrische Schicht mit der, wiederum nach aussen, anschliessenden Metallfläche, die erwähnte DC-Entkopplungskapazität.

Im weiteren wird, dem Wortlaut von Anspruch 7 folgend, vorgeschlagen, die gesamte Rezipienteninnenfläche aus einem werkstück- und prozessangepassten dielektrischen Material auszubilden, womit die oben abgehandelte Kontaminationsgefahr gänzlich behoben wird.

In vielen Fällen wird man nicht die gesamte Rezipientenwandungsfläche als Elektrodenfläche einsetzen, sondern, dem Wortlaut von Anspruch 8 folgend, eine zwischen den Elektroden gelegene Partie der Rezipientenwandung mit einer gegen das Rezipienteninnere gelegenen, dielektrischen Schicht versehen.

Dabei ist es, dem Wortlaut von Anspruch 9 folgend, ohne weiteres möglich, dort diese Schicht so dick auszubilden, dass die Rezipientenwandung dort aus dieser dielektrischen Schicht besteht. Dies deshalb, weil in solchen Zwischenpartien keine elektrische Energie übertragen werden muss.

Um nun die Plasmadichte des Plasmas, das bis anhin als kapazitiv erzeugt beschrieben wurde, zu erhöhen und dabei gleichzeitig die Ionenenergie zu verringern, wird vorgeschlagen, dem Wortlaut von Anspruch 10 folgend, eine Spulenanordnung zur induktiven Energieeinkopplung in das Plasma vorzusehen, wozu sich der erwähnte, dielektrische Zwischenabschnitt ausgezeichnet eignet, denn bei Vorsehen einer Spulenanordnung zur Erzeugung eines Induktionsfeldes im Inneren des Rezipienten ist es unumgänglich, den Wandungsabschnitt zwischen Spule und Rezipienteninnerem dielektrisch auszubilden oder die Spule gegen das Rezipienteninnere freiliegend anzuordnen.

Berücksichtigt man weiter, dass die vorgesehene Spulenanordnung eine elektronenleitende Anordnung ist, mit einer dem Rezipienteninneren zugewandten Fläche, so erkennt man ohne weiteres, dass eine solche Spulenanordnung mit einer nach innen angrenzenden dielektrischen Schicht dieselbe Struktur bildet, wie sie nach dem Wortlaut von Anspruch 2 als kapazitive Elektrode vorgeschlagen wurde, oder, gegen das Rezipienteninnere freiliegend, einen metallischen Wandungsteil bildet.

Mithin ist es ohne weiteres möglich, zum Erhalt der erwähnten Flexibilität bezüglich Flächenverhältnisauslegung, die Spule galvanisch mit der einen der Elektroden zur kapazitiven Plasmaerzeugung zu verbinden und, im Falle einer erfindungsgenässen Elektrode nach Anspruch 2, die durch Spule und angrenzende dielektrische Schicht gebildete Struktur zusätzlich als Fläche einer solchen kapazitiven Elektrode zu verwenden, nach Anspruch 11.

Dabei wird, dem Wortlaut von Anspruch 12 folgend, weiter vorgeschlagen, dass in diesem Abschnitt die metallische Spulenanordnung mindestens einen wesentlichen Teil der Vakuumbelastung der Rezipientenwandung aufnimmt. Es ist ohne weiteres möglich, die den Rezipienten umschlingende Spule aus Flachbandmaterial auszubilden, womit eine hohe mechanische Stabilität bezüglich radialer Belastungskräfte erzielt wird und eine grosse, dem Rezipienteninneren zugewandte Fläche.

Im Hinblick auf die Aufgabenstellung, die der vorliegenden Erfindung zugrundeliegt, ist auch ersichtlich, dass dann, wenn die zusätzlich vorgesehene Spulenanordnung auch als Fläche der kapazitiven Elektrode verwendet wird, das Vorsehen der Spulenanordnung die Bauhöhe des Rezipienten nicht zusätzlich zu vergrössern braucht.

Nach dem Wortlaut von Anspruch 13 wird nun weiter ein Verfahren zum Zünden einer Plasmaentladung in einem Vakuumrezipienten vorgeschlagen, welches sich dadurch auszeichnet, dass das Plasma zunächst kapazitiv gezündet wird und darnach induktiv verstärkt. Ein solches Zündverfahren eignet sich selbstverständlich ausgezeichnet zum Zünden der oben erwähnten erfindungsgemässen Anlage ohne weitere Zündhilfen.

Im weiteren wird nach dem Wortlaut von Anspruch 14 ein Verfahren zum intermittierenden Betreiben einer Plasmaentladung in einem Vakuumrezipienten vorgeschlagen, bei welchem, zum Stillsetzen des Prozesses, nur die kapazitiven Elektroden elektrisch desaktiviert werden und ein induktiv erzeugtes Plasma im Prozessraum aufrechterhalten wird, darnach der Prozess durch Wiederaktivierung der kapazitiven Elektroden wieder aufgenommen wird.

Dadurch wird ermöglicht, mit dem erfindungsgemässen Zünden bzw. erfindungsgemässen intermittierenden Betrieb, bevorzugterweise in Kombination eingesetzt, die Anordnung ohne speziell vorgesehene Zündeinrichtung zu zünden und intermittierend zu betreiben.

In Anspruch 15 ist das erfindungsgemässe galvanische Koppeln einer vorgesehenen Spulenanordnung zur induktiven Plasmaerzeugung mit einer der vorgesehenen Elektroden zum kapazitiven Erzeugen des Plasmas spezifiziert, womit grundsätzlich eine bessere Ausnützung der Rezipientenbaugrösse ermöglicht wird bzw. deren Verkleinerung.

Die Erfindung wird anschliessend beispielsweise anhand von Figuren erläutert.

Es zeigen:

Fig. 1 schematisch eine erfindungsgemässe Aetzoder Beschichtungsanlage, bei der der Rezipient beide Elektroden zur kapazitiven Plasmaerzeugung bildet,

Fig. 2 schematisch an einem Ausschnitt eines Rezipienten dargestellt, die Ausbildung einer der Elektroden zur kapazitiven Erzeugung des Plasmas nach einer zweiten erfindungsgemässen Lösung,

Fig. 3 schematisch ein Anlagenrezipient, bei dem beide Elektroden zur kapazitiven Plasmaerzeugung nach der Ausführung von Fig. 2 ausgebildet sind und zudem der Rezipient nach der Ausführung von Fig. 1 im wesentlichen durch Elektrodenfläche gebildet ist,

Fig. 4 ausgehend von einem bekannten Anlagenrezipienten mit Elektroden zur kapazitiven Erzeugung des Plasmas, die Weiterbildung mit vorgesehener Spulenanordnung zur induktiven Energieeinspeisung ins Plasma, wobei erfindungsgemäss die Fläche der Spulenanordnung als Teil der Fläche einer der Elektroden zur kapazitiven Plasmaerzeugung ausgenützt wird,

Fig. 5 schematisch ein erfindungsgemässer Anlagenrezipient mit einer der Elektroden zur kapazitiven Plasmaerzeugung, ausgebildet nach Fig. 2, und mit einer Spulenanordnung, wobei die Fläche der Spulenanordnung Teil der Elektrode nach Fig. 2 bildet.

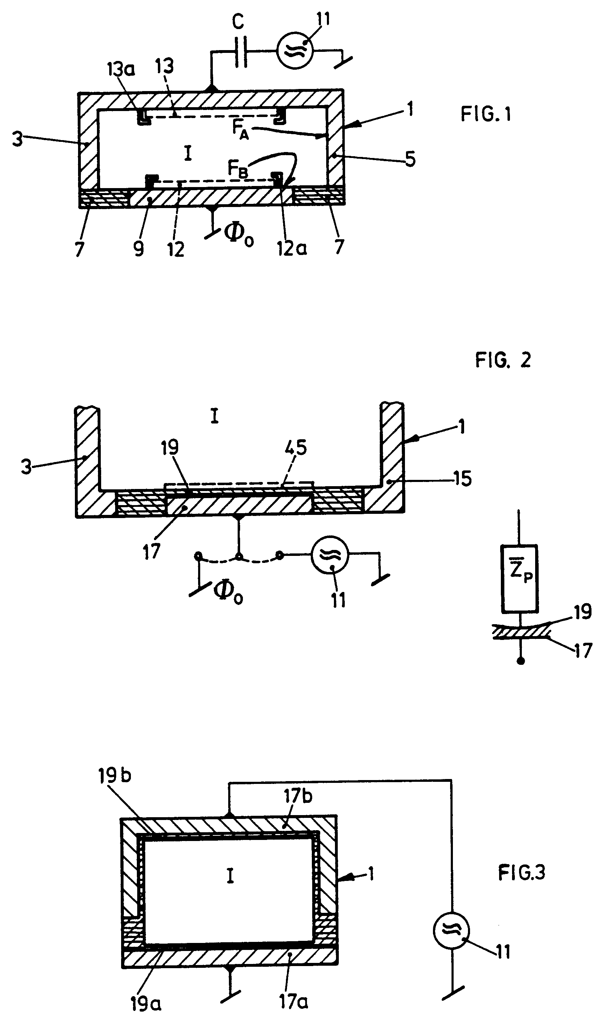

In Fig. 1 ist ein Vakuumrezipient 1 schematisch dargestellt. Seine Wandung 3, welche den Rezipienteninnenraum I ummantelt und woran selbstverständlich, und hier nicht dargestellt, Vakuumpumpen, Gaseinlässe für Arbeitsgas, wie Argon, und/oder für ein Reaktivgas etc. angeschlossen sind, umfasst einen ersten Teil 5 aus Metall sowie, davon über einen Zwischenisolator 7 getrennt, einen zweiten metallischen Teil 9. Die metallischen Teile 5 und 9 bilden je eine der zwei Elektroden zur kapazitiven Plasmaerzeugung.

Es ist, beispielsweise der obere Teil 5, über eine Entkopplungskapazität C auf einen Hochfrequenzgenerator 11 geschaltet, generell einen AC-Generator, während im dargestellten Beispiel der zweite, als Elektrode wirkende Teil 9, auf ein Bezugspotential $\emptyset$o, beispielsweise auf Massepotential, gelegt ist. Es bildet die Innenwandung des Teiles 5 die eine Elektrodenfläche $F_A$, während die Innenwandung des Teiles 9 die zweite Elektrodenfläche $F_B$ bildet, dem Prozessraum bzw. Innenraum I des Rezipienten 1 zugewandt.

Es ist ersichtlich, dass bei dieser Ausbildung des Rezipienten 1 höchste Flexibilität besteht, wie das Verhältnis der beiden Flächen $F_A$ zu $F_B$ gewählt werden soll. Zum Aetzen eines Werkstückes wird letzteres, wie bei 12 gestrichelt dargestellt, auf den Elektrodenteil 9 gelegt, d.h. auf denjenigen, der eine wesentlich kleinere Elektrodenfläche $F_B$ bildet, während es zum Beschichten, wie bei 13 dargestellt, auf den Elektrodenteil 5 gelegt wird, der eine wesentlich grössere Elektrodenfläche $F_A$ festlegt. Im letzterwähnten Fall wird vorzugsweise die grössere Elektrode, also hier der Teil 5, auf Bezugspotential $\emptyset$o betrieben.

In Fig. 2 ist eine zweite erfindungsgemässe Anlagenbzw. Rezipientenanordnung dargestellt.

Am hier nur ausschnittsweise dargestellten Rezipienten 1, beispielsweise mit metallischer Wandungspartie 15, ist (hier nicht dargestellt) eine erste Elektrode zur kapazitiven Plasmaerzeugung vorgesehen, bei welcher es sich um einen Rezipientenwandungsteil, dem Konzept von Fig. 1 folgend, handeln kann, aber auch um eine Elektrode, welche in herkömmlicher Art und Weise mittels einer vakuumdichten Durchführung, isolierend durch die Rezipientenwandung` betrieben ist. In Fig. 2 ist eine erfindungsgemäss aufgebaute Elektrode dargestellt. Sie weist in ihrem Grundaufbau eine elektronenleitende, metallische Lage 17 auf, bezüglich des Rezipienteninnern I aussenliegend, diesbezüglich durch eine Schicht 19 aus einem dielektrischen Material abgedeckt.

Zur Aufnahme der durch das im Rezipienteninneren I herrschende Vakuum bewirkten Belastung der Rezipientenwandung 3 ist die elektronenleitende Lage 17 bevorzugterweise relativ dick dimensioniert, damit diese Belastung durch diese Lage aufgenommen wird. Die dielektrische Lage 19 kann dann beliebig dünn ausgebildet werden. Die erfindungsgemässe Elektrode am Vakuumrezipienten 1, in ihrer Grundstruktur gebildet durch die aussenliegende elektronenleitende Lage 17 und die dielektrische Schicht 19, bildet wie folgt eine DC-Entkopplungskapazität:

Im Prozessraum, worin das Plasma unterhalten wird, liegen freie Ladungsträger vor. Somit bildet der Prozessraum, innen an der dielektrischen Schicht 19 anliegend, bezüglich der Lage 17 eine Gegenkapazitätsplatte. Vereinfacht kann die Anordnung der elektronenleitenden Lage 17, der Dielektrikumsschicht 19 und des angrenzenden Prozessraumes, wie rechts in Fig. 2 dargestellt, durch eine Prozessimpedanz $\overline{Z}_P$ und die für DC-Anteile dazu seriegeschaltete Elektrodenkapazität mit der dielektrischen Lage 19 und der elektronenleitenden Lage 17 dargestellt werden.

Wie in Fig. 2 in einer Alternative dargestellt, wird diese Elektrode zur kapazitiven Plasmaerzeugung im Rezipienten auf Bezugspotential $\emptyset$o gelegt oder, in der anderen Alternative, mit dem AC-, insbesondere Hochfrequenzgenerator 11 verbunden. Die DC-Entkopplungskapazität C, die bei der Anordnung gemäss Fig. 1 vorzusehen ist, damit der Elektrodenteil 5 das self-bias-Potential einnehmen kann, wird durch die erwähnte Kapazität zwischen Lage 17 und Prozessraum I gebildet.

Die dielektrische Lage 19 wird bevorzugterweise aus einem Material gefertigt, welches mit dem Behandlungsprozess eines Werkstuckes kompatibel ist, und zwar in dem Sinne, dass ein Abtragen dieses Schichtmaterials das Prozessresultat nicht negativ beeinträchtigt. Bei der Behandlung eines Werkstückes mit $SiO_2$-Oberfläche wird mithin die Schicht 19 vorzugsweise aus $SiO_2$ gebildet.

Die anhand von Fig. 2 dargestellte Elektrode kann über beliebig grosse Bereiche der Rezipientenwandung 3 ausgelegt sein, womit auch hier eine hohe Flexibilität dahingehend besteht, wie das Verhältnis zwischen grosser Elektrodenfläche und kleiner Elektrodenfläche auszulegen ist.

In Fig. 3 ist, als Beispiel, ein erfindungsgemässer Rezipient 1 dargestellt, bei welchem beide Elektroden zur kapazitiven Plasmaerzeugung nach Art der in Fig. 2 dargestellten aufgebaut sind. Es ist ersichtlich, dass damit die Möglichkeit besteht, das ganze Rezipienteninnere gezielt, und höchsten Reinheitsanforderungen genügend, aus einem prozesskompatiblen, dielektrischen Material auszubilden.

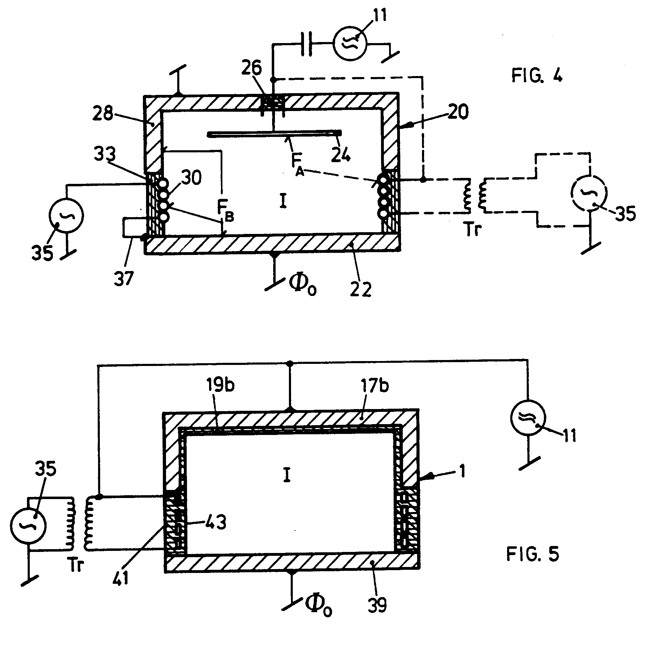

In Fig. 4 ist schematisch ein Rezipient 20 dargestellt, dessen Teile 22 und 28 in bekannter Art und Weise auf Bezugspotential $\emptyset$o, beispielsweise Massepotential, gelegt ist. Dieser Teil 22 wirkt als die eine der Elektroden zur kapazitiven Plasmaerzeugung. Die zweite Elektrode hierfür, 24, ist, wie bekannt, über einen Durchführungsisolator 26 durch die metallische Wandung 28 des Rezipienten 20 betrieben. In einem Zwischenabschnitt 30 der Rezipientenwand ist eine Spulenanordnung 33 angeordnet, um den Rezipienten herum. Die Spule ist mit einem AC-Generator 35 verbunden, welcher den Spulenstrom liefert. Durch Wirkung des durch die Spule 33 bewirkten magnetischen Induktionsfeldes im Rezipienteninneren I bzw. im Prozessraum zwischen den Elektroden 24 und 22/28 wird die Plasmadichte erhöht, die Ionenenergie erniedrigt, so dass ein gleichmässigeres und "sanfteres" Beschichten bzw. Aetzen eines Werkstückes möglich wird, verglichen mit einer Bearbeitung mittels eines nur kapazitiv erzeugten Plasmas.

Wie nun aus Fig. 4 ersichtlich, liegt, erfindungsgemäss, die Innenfläche der Spulenanordnung 30 gegen das Rezipienteninnere I frei. Der AC-Generator 35 zur Lieferung des Spulenstromes ist in Serie mit der vakuumdicht gekapselten Spule 33, darnach mit dem als eine der Elektroden wirkenden Teil 22 des Rezipienten verbunden, welch letzterer auf Bezugspotential Øo gelegt ist. Mithin ist die Spule 33 DC-mässig auf Bezugspotential Øo gelegt, womit die nach innen freiliegende Spulenfläche Teil der Elektrodenfläche des Rezipienteiles 22 wird. Damit ist es möglich, trotz Vorsehen einer Spulenanordnung 33, den Rezipienten im wesentlichen gleich kompakt aufzubauen wie ohne Vorsehen einer Spulenanordnung 33, bei gegebenem Verhältnis der Elektrodenflächen $F_A$, $F_B$. Wird die Spule 33 nicht mit dem auf Bezugspotential gelegten Teil 22 bzw. der auf Bezugspotential gelegten Elektrode galvanisch verbunden betrieben, so wird, wie gestrichelt rechts in Fig. 4 dargestellt, die Spule 33 beispielsweise über einen Trenntransformator Tr mit dem AC-Generator 35 verbunden und galvanisch mit der Elektrode 24 verbunden. Damit kann einerseits auch die Spule 33 das self-bias-Potential einnehmen und wird durch Generator 11, transformatorisch gekoppelt, durch den Generator 35 betrieben.

In diesem Falle trägt die Spule 33 zur Fläche der Elektrode 24 zur kapazitiven Plasmaerzeugung bei.

In Fig. 5 ist die anhand von Fig. 4 dargestellte Technik zur Ausnützung der Fläche einer zur induktiven Plasmaerzeugung vorgesehenen Spule eingesetzt, zusammen mit der Ausbildung mindestens einer der Elektroden zur kapazitiven Plasmaerzeugung nach Fig. 2. Im dargestellten Beispiel wird die eine der Elektroden zur kapazitiven Plasmaerzeugung durch einen metallischen Teil 39 des Rezipienten 1 gebildet. Dieser Teil z.B. ist wiederum auf Bezugspotential Øo gelegt. Die zweite Elektrode zur kapazitiven Plasmaerzeugung wird analog zur Ausführung gemäss Fig. 2 durch eine elektronenleitende Lage 17b, einen Metallteil, gebildet, mit einer dem Rezipienteninneren I zugewandten dielektrischen Lage bzw. Schicht 19b. Die metallische Lage 17b ist, gemäss den Ausführungen zur Schaltungskonfiguration einer Elektrode nach Fig. 2, ohne weitere DC-Entkopplung mit dem AC-Generator 11 verbunden.

Eine Spulenanordnung 41 ist in einem Bereich 43 des Rezipienten vorgesehen, gegen das Rezipienteninnere I hin abgedeckt durch dielektrisches Material, wie durch Weiterführung der dielektrischen Schicht 19b. Da im hier dargestellten Ausführungsbeispiel die Spule 41 mit ihrer dem Rezipienteninneren zugewandten Fläche als Flächenvergrösserung der durch den Teil 17b gebildeten Lage wirken soll, wird die Spule 41 über einen Trenntransformator Tr mit dem AC-Generator 35 verbunden und ist weiter, galvanisch, mit dem Teil 17b verbunden.

Im Bereich 43 nimmt dabei bevorzugterweise der Körper der Spule 41 die mechanische Vakuumbelastung auf und ist, um eine möglichst grosse wirksame Fläche, die gegen das Rezipienteninnere gewandt ist, zu ergeben, wie schematisch dargestellt, als Flachbandwicklung ausgebildet.

Rückblickend auf die erfindungsgemässe Ausbildung der Elektrode nach Fig. 2 kann ausgeführt werden, dass diese Anordnung selbstverständlich auch eine metallische, dem Rezipienteninneren zugewandte dritte Schicht umfassen kann, wenn bevorzugt wird, dem Behältnisinneren zugewandt, eine metallische Wandung vorzusehen. Dabei ist ersichtlich, dass eine derartige, bei 45 gestrichelt dargestellte, metallische Schicht oder ein entsprechender Metallkörper je nach erwünschtem Material leicht ausgewechselt werden kann und einem jeweiligen Prozess angepasst werden kann.

Eine Anordnung mit einem Vakuumrezipienten, einem Paar von Elektroden zur kapazitiven Plasmaerzeugung und zusätzlich einer Spulenanordnung zur induktiven Plasmaerzeugung, wie grundsätzlich in Fig. 4 dargestellt, aber unabhängig von der anhand von Fig. 4 dargestellten speziellen Ausnützung der Spulenfläche, wird erfindungsgemäss gezündet, indem zuerst das Plasma kapazitiv aufgebaut und darnach induktiv verstärkt wird. Dies heisst, bei der Ausführungsvariante beispielsweise gemäss Fig. 4, wird, zum Zünden, zuerst der AC-Generator 11 in Betrieb gesetzt und darnach der den Spulenstrom liefernde AC-Generator 35.

Zum intermittierenden Betrieb des im Rezipienten durchgeführten Aetz- oder Beschichtungsprozesses wird, zum Stillsetzen des Prozesses, die kapazitive Plasmaerzeugung, d.h. am Beispiel von Fig. 4 betrachtet, der AC-Generator 11, stillgesetzt, während der Generator 35, welcher den Spulenstrom liefert, elektrisch aktiviert bleibt. Zum Wiederstarten des Prozesses wird bei aktiviert gebliebenem, induktiven Anteil lediglich der kapazitive durch Wiederaufschalten des Generators 11 in Betrieb gesetzt.

Wie erwähnt wurde, wird am erfindungsgemässen Rezipienten ein zu behandelndes Werkstück, wenn es zu ätzen ist, im Bereich der Elektrode mit kleinerer, dem Rezipienteninneren zugewandter Fläche vorgesehen, wozu, in diesem Falle, im Bereich dieser kleineren Elektrode eine Halterungsvorrichtung für zu ätzende Werkstücke vorgesehen ist. Eine solche Halterung ist in Fig. 1 mit 12a schematisch dargestellt.

Analog wird für ein zu beschichtendes Werkstück an derjenigen Elektrode mit der grösseren Fläche, wie in Fig. 1 bei 13a schematisch dargestellt, eine Werkstückhalterung vorgesehen.

Es versteht sich von selbst, dass auch hier in bekannter Weise ein Magnetfeld im Entladungsraum zur Wirkung gebracht werden kann zur örtlich gezielten Erhöhung der Plasmadichte bzw. Steuerung der Plasmaverteilung. Ein solches Feld wird durch vorzugsweise ausserhalb der Kammer angeordnete Permanent- und/oder Elektromagnete erzeugt, stationär montiert oder bewegt.

**Patentansprüche**

1. Verfahren zum Zünden einer Triodenätz- oder -beschichtungsanlage mit einem Paar beabstandeter Elektroden zur kapazitiven Plasmaerzeugung sowie einer spulenanordnung zur induktiven Energieeinkopplung ins Plasma, dadurch gekennzeichnet, dass zunächst ein Plasma zwischen den Elektroden kapazitiv erzeugt wird und darnach zusätzlich induktiv Energie eingekoppelt wird.

2. Verfahren zum intermittierenden Betreiben einer Ätz- oder Beschichtungsanlage mit einem Paar beabstandeter Elektroden zur kapazitiven Plasmaerzeugung sowie einer Spulenanordnung zur induktiven Energieeinkopplung in das Plasma, dadurch gekennzeichnet, dass man für das Stillsetzen des Behandlungsprozesses die beabstandeten Elektroden zur kapazitiven Plasmaerzeugung elektrisch desaktiviert, dabei das Plasma induktiv aufrechterhält und zur Wiederaufnahme des Prozesses die Elektroden zur kapazitiven Plasmaerzeugung elektrisch wieder aktiviert.

3. Ätz- oder Beschichtungsanlage mit einem Paar, mit einem ersten Generator wirkverbundenen, beabstandeter Elektroden zur kapazitiven Plasmaerzeugung sowie einer mit einem zweiten Generator wirkverbundenen Spulenanordnung zur induktiven Energieeinkopplung in das Plasma, dadurch gekennzeichnet, dass die Wirkverbindung der Elektroden zum ersten Generator intermittierend ist, innerhalb von Zeitspannen, während welchen die Wirkverbindung zwischen Spulenanordnung und zweitem Generator erstellt ist.

FIG. 1

FIG. 2

FIG.3

FIG. 4

FIG. 5